# EUROPEAN PATENT APPLICATION

(11) **EP 4 563 358 A1**
(43) Date of publication of application: **04.06.2025**
(21) Application number: 23846674.2
(22) Date of filing: 28.07.2023
(51) Int. Cl.: B41J 2/16

(54) **INKJET HEAD MANUFACTURING METHOD AND INKJET HEAD**

(30) Priority: 28.07.2022 JP 2022120156
(71) Applicant: KONICA MINOLTA, INC., Tokyo 100-7015 (JP)
(72) Inventor: MASHIMA Hideki, Tokyo 100-7015 (JP); HARA Shintaro, Tokyo 100-7015 (JP); MATSUSHITA Yuji, Tokyo 100-7015 (JP); KOBAYASHI Ryohei, Tokyo 100-7015 (JP)
(74) Representative: MFG Patentanwälte Meyer-Wildhagen Meggle-Freund Gerhard PartG mbB
(86) International application number: PCT/JP2023/027763
(87) International publication number: WO 2024/024944

(57) **Abstract**

This display member (200) comprises an optical surface on which a predetermined treatment is performed and a member engagement section (202) that is connected to the optical surface and gripped by a first engagement member and a second engagement member of jigs (302). The member engagement section (202) has a thick section connected with a thin section of a smaller size than the thick section. A first relation in which the first engagement member and the second engagement member are separated from each other is obtained when the jigs (302) approach and pass over the thick section, and when said jigs (302) subsequently arrive at the thin section, a second relation is obtained in which the first engagement member and the second engagement member are brought closer together than while in the first relation. The member engagement section (202) is in line contact or surface contact with both the first engagement member and the second engagement member at least while in the second relation. The member engagement section (202) is clamped by the first engagement member and the second engagement member while in the second relation and is thereby held via the jigs (302) during the predetermined treatment.

## Description

### Technical Field

The present invention relates to an inkjet head manufacturing method and an inkjet head.

### Background Art

Conventionally, there has been an inkjet head that causes ink to be ejected from each of a plurality of nozzles so that the ink lands on a target medium. In this inkjet head, variations in pressure applied to ink ejected from the nozzles has been a problem.

In a piezoelectric inkjet head, deformation corresponding to a voltage applied to a piezoelectric member is used to apply pressure to ink. In a piezoelectric inkjet head, variations in the characteristics of the piezoelectric member lead to the variations in the pressure applied to ink. Patent Document 1 discloses a technique of offsetting the variations by changing the areas of electrodes (individual electrodes) located so as to overlap the piezoelectric members in accordance with variations in the thickness of the piezoelectric members during manufacturing.

### Citation List

### Patent Literature

Patent Document 1: JP 2006-156987A

### Summary of Invention

### Technical Problem

However, even if the outer shapes of the piezoelectric members are made uniform, variations still occur in the pressure, that is, in ink ejection. There is a demand for appropriately suppressing these variations.

An object of the present disclosure is to provide an inkjet head manufacturing method and an inkjet head with less variations in the ink ejection .

### Solution to Problem

In order to achieve the above object, the invention recited in claim 1 is a method for manufacturing an inkjet head configured to apply a voltage to a piezoelectric member to deform the piezoelectric member, thereby applying a pressure fluctuation to ink to cause the ink to be ejected, the method comprising: correcting a distribution of an ejection speed of the ink by a structure that corresponds to a polarization characteristic of the piezoelectric member.

The invention recited in claim 2 is the method for manufacturing an inkjet head according to claim 1, wherein the polarization characteristic is defined by residual polarization.

The invention recited in claim 3 is the method for manufacturing an inkjet head according to claim 2, wherein an area of an electrode configured to apply a voltage to the piezoelectric member is made smaller for a portion having a larger residual polarization of the piezoelectric member.

The invention recited claim 4 is an inkjet head comprising: piezoelectric elements that include respective piezoelectric members and respective electrodes configured to apply a voltage to the piezoelectric members; and ink channels that include respective pressure chambers configured to deform in accordance with an operation of the respective piezoelectric elements, thereby applying a pressure fluctuation to ink, wherein the electrodes each have an area corresponding to a polarization characteristic of the respective piezoelectric members.

The invention recited in claim 5 is an inkjet head comprising: piezoelectric elements that include respective piezoelectric members and respective electrodes configured to apply a voltage to the piezoelectric members; and ink channels that include respective pressure chambers configured to deform in accordance with an operation of the respective piezoelectric elements, thereby applying a pressure fluctuation to ink, wherein the piezoelectric members each have an area corresponding to a polarization characteristic of the respective piezoelectric members in a plan view along a stacking direction of the piezoelectric members and the electrodes.

The invention recited in claim 6 is an inkjet head comprising: piezoelectric elements that include respective piezoelectric members and respective electrodes configured to apply a voltage to the piezoelectric members; and ink channels that include respective pressure chambers configured to deform in accordance with an operation of the respective piezoelectric elements, thereby applying a pressure fluctuation to ink, wherein the pressure chambers each have an area corresponding to a polarization characteristic of the respective piezoelectric members in a plan view along a stacking direction of the piezoelectric members and the electrodes.

The invention recited in claim 7 is the inkjet head according to any one of claims 4 to 6, wherein the polarization characteristic is defined by residual polarization.

### Advantageous Effects of Invention

According to the present invention, there is an effect that it is possible to obtain an inkjet head with less variations in the ink ejection.

### Brief Description of Drawings

[FIG. 1A] This is a schematic cross-sectional view of a structure around a certain nozzle in a head chip of an inkjet head.
[FIG. 1B] This is a diagram schematically illustrating a structure around the certain nozzle in the head chip of the inkjet head.
[FIG. 2] This is a graph illustrating polarization characteristics of a piezoelectric member.
[FIG. 3A] This is a graph illustrating an example of variations in residual polarization.
[FIG. 3B] This is a graph illustrating an experimental result of an example of correction of the areas of electrodes with respect to the variations in residual polarization.
[FIG. 4A] This is a graph illustrating an example of the amount of charge and the ejection speed.
[FIG. 4B] This is a graph illustrating an experimental result of an example of correction of the amount of charge and the ejection speed in accordance with the correction of the areas of electrodes.
[FIG. 5] This is a graph illustrating an ink ejection speed change rate with respect to a change of a parameter related to offset of variations in a polarization characteristic, represented as a relative change with respect to a reference parameter value.
[FIG. 6A] This is a flowchart illustrating a procedure of a design adjustment process related to manufacturing of a head chip.
[FIG. 6B] This is a flowchart illustrating a procedure of a manufacturing process of the head chip.

### Description of Embodiments

Hereinafter, embodiments of the present invention will be described with reference to the drawings.

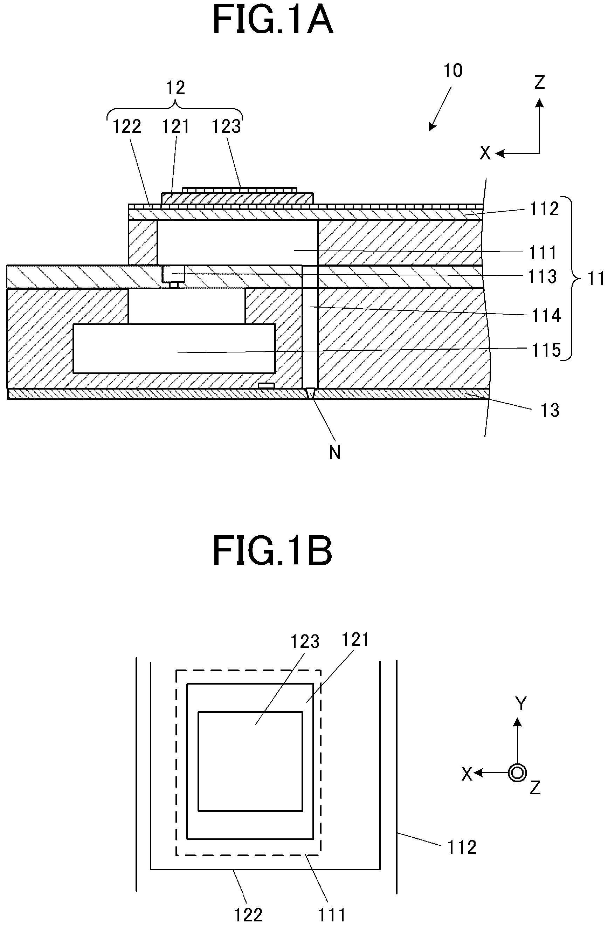

FIG. 1A and FIG. 1B are diagrams schematically illustrating structures around a certain nozzle N in a head chip 10 of an inkjet head 1 according to the present embodiment. In fact, the head chip 10 has a plurality (a large number) of nozzles N. The nozzles N are arranged on a bottom surface (surface on the -Z side) of the head chip 10 at intervals according to the resolution or the like. The nozzles N may be arranged in two dimensions. FIG. 1A illustrates a cross section parallel to an ink ejection direction of the head chip 10. The head chip 10 includes a channel member 11, vibration sections 12 (piezoelectric elements), and a nozzle plate 13. The nozzle plate 13 is disposed on the bottommost surface (on the -Z side) and has the nozzles N. The channel member 11 has a plurality of layers stacked to form hollow pressure chambers 111 inside. Below the pressure chambers 111 (on the -Z side), a common supply path 115 extends in the Y direction. Ink is supplied to each of the pressure chambers 111 through an upstream supply path 113 that branches from the common supply path 115 and extends in the Z direction. The pressure chamber 111 communicates with a nozzle N via a downstream supply path 114. The upper surface of the pressure chamber 111 (on the +Z side) is covered with a vibration plate 112. The pressure chamber 111, the upstream supply path 113, and the downstream supply path 114 are collectively referred to as an ink channel for each of the nozzles N.

Note that the ink channel is not limited to the above-described positional relationship. For example, the common supply path 115 and the upstream supply path 113 may be located above the pressure chamber 111 (on the +Z side), and the nozzle N may be directly connected to a bottom surface (surface on the -Z side) of the pressure chamber 111. The channel member 11 is insulating and can be precisely processed. For example, the channel member 11 is a glass substrate, a Si substrate, or a resin substrate such as polyimide. Members of the plurality of layers may be different from each other. Note that a conductive layer (such as SUS) may be included in part as long as it is separated from the vibration sections 12. The layer separated from the vibration sections 12 is, for example, the nozzle plate 13. Further, the vibration plate 112 may be used in combination with a lower electrode 122 of each of the vibration sections 12. In this case, the material of the vibration plate 112 conforms to the material of the lower electrode 122.

Each of the vibration sections 12 is disposed above the pressure chamber 111 with the vibration plate 112 interposed therebetween. The vibration section 12 is disposed in a region where at least a portion of the vibration section 12 overlaps the pressure chamber 111 in a plan perspective view. In the vibration section 12, a lower electrode 122, a piezoelectric member 121, and an upper electrode 123 are stacked and bonded in this order from the lower side (-Z side). The lower electrode 122 is bonded to the vibration plate 112. The piezoelectric member 121 deforms in accordance with the potential difference between the lower electrode 122 and the upper electrode 123. The vibration plate 112 deforms corresponding to the deformation of the piezoelectric member 121, causing the size (volume) of the pressure chamber 111 to change. This imparts a pressure fluctuation to the ink inside the pressure chamber 111.

Although not particularly limited, here, the lower electrode 122 is a common electrode, disposed across a plurality of sets of the pressure chambers 111 and the piezoelectric members 121 (for example, extending in the Y direction). A common potential, for example, a ground potential is applied to the bottom surface of each of the piezoelectric members 121 via the lower electrode 122. The upper electrode 123 is an individual electrode (according to the present disclosure). When the potential (voltage) is individually set for each of the upper electrodes 123, the piezoelectric member 121 deforms according to a potential difference (applied voltage) between the upper electrode 123 and the lower electrode 122. A change pattern of the potential difference (voltage) can be appropriately defined. Thus, the presence or absence of ink ejection and the amount of the ejection from each of the nozzles N in accordance with the amount of deformation and frequency of periodic deformation of the piezoelectric member 121 can be defined.

The piezoelectric member 121 is mainly a ferroelectric material such as lead zirconate titanate (PZT). The lower electrode 122 and the upper electrode 123 are not particularly limited as long as they are made of a metal having high electrical conductivity. For example, titanium, iridium, platinum, chromium, gold, or the like, or a combination thereof (an alloy or a plurality of individual layers) can be selected for the lower electrode 122 and the upper electrode 123. The upper electrode 123 and the lower electrode 122 may be made of different materials. The vibration section 12 is obtained by forming three layers of the lower electrode 122, the piezoelectric member 121, and the upper electrode 123 in this order on the vibration plate 112.

The vibration plate 112 is, for example, a thin Si substrate that is elastically deformable . A portion of the vibration plate 112 faces the pressure chamber 111 and is vibratable, and the other portion is bonded and fixed to the channel member 11 and the like.

These structures of the head chip 10 are obtained with high precision by, for example, a manufacturing method of a micro electro mechanical system (MEMS) structure using a semiconductor process. For a film formation of the piezoelectric member 121, a sputtering method or a sol-gel method can be used, for example. To the lower electrode 122, a conductor that connects to the upper side of a via (not shown) penetrating the channel member 11 is connected, for example. The head chip 10 includes, above the channel member 11, a circuit member having an electric circuit (conductor) on its upper surface. Each signal line of the electric circuit connects each of the upper electrodes 123, the via, and the like to a connection terminal disposed on the circuit member. The connection terminal is connected to a circuit board (for example, a flexible printed circuit (FPC) or the like) including a drive IC that outputs the change pattern of the potential difference. This connection portion may be connected using an anisotropic conductive film (ACF), an anisotropic conductive paste (ACP), a silver paste, or the like.

Further, the circuit member may have an ink supply path. The ink supply path communicates with the common supply path 115 and an ink reservoir located further above the circuit member.

The inkjet head 1 according to the present embodiment includes the circuit member, the ink reservoir, and the circuit board in addition to the head chip 10. Note that the inkjet head 1 may include a common circuit board for a plurality of head chips 10, circuit members, and ink reservoirs. The inkjet head 1 may include other components such as a heating section (heater) and a temperature measuring section (thermistor or the like) for heating and keeping warm the ink or the like.

FIG. 1B is a plan view of the vibration section 12 from above.

In the inkjet head 1, the vibration section 12 disposed on the vibration plate 112 has the plan view sizes (areas) of the lower electrode 122, the piezoelectric member 121, and the upper electrode 123 different from the plan view area of the invisible pressure chamber 111 located below the vibration plate 112. The piezoelectric member 121 has a plan view size smaller than the lower electrode 122 located below. The plan view size of the upper electrode 123 is further smaller than these. The plan view size of the lower electrode 122, which is a common electrode, is larger than the plan view size of the pressure chamber 111. Here, the plan view size of the pressure chamber 111 is larger than the plan view size of the piezoelectric member 121.

The lower electrode 122 may be provided separately for each set of the pressure chamber 111 and the piezoelectric member 121. In this case, a voltage may be individually applied to each of the lower electrodes 122, while a common voltage is applied to the upper electrodes 123. In addition, the lower electrode 122 may have a coating for the ink on the side facing the pressure chamber 111, so that the lower electrode 122 itself may also serve as a vibration plate 112, facing the pressure chamber 111.

Note that although the plan view shapes of the lower electrode 122, the piezoelectric member 121, the upper electrode 123, and the pressure chamber 111 are illustrated herein as rectangles, they are not limited thereto. These plan view shapes may be circular, elliptical, rectangular with some or all corners rounded, or other polygons or those polygons with rounded corners. In addition, these shapes are not necessarily similar to each other.

The plan view area of the upper electrode 123 in contact with the piezoelectric member 121 corresponds to the amount of vibration of the piezoelectric member 121. That is, when the same voltage is applied, if a region of the piezoelectric member 121 exposed to the electric field caused by the voltage varies, the amount of deformation of the entire piezoelectric member 121 will also vary. The difference in the deformation amount of the piezoelectric member 121 affects the ejection amount (speed) of the ink. Therefore, the plan view area of the upper electrode 123 is suitably determined as described later.

In addition, variations in the thickness and the area of the piezoelectric member 121 affect the ejection amount (speed) of the ink. Therefore, they also need to be suitably determined. Objects to be determined here may include, in particular, a difference between the lengths of the shortest straight line connecting two points on the outer periphery and passing through the center of the respective piezoelectric members 121, that is, a difference between the diameter of a circle, the minor axis of an ellipse, the short side length of a rectangular parallelepiped, and the like.

Since the piezoelectric member 121 is appropriately polarized in the Z direction, the piezoelectric member 121 is deformed when a potential difference is generated between the upper electrode 123 and the lower electrode 122. The deformation direction is perpendicular to the Z direction, which is the X direction here. However, since the lower electrode 122 is fixed to the vibration plate 112, the deformation of the piezoelectric member 121 in the X direction is restrained. This causes distortion between the side facing the lower electrode 122 and the side facing the upper electrode 123, the latter of which is a free end, thereby deflecting and deforming the piezoelectric member 121. In response to the deformation, the vibration plate 112 vibrates in the Z direction to change the volume of the pressure chamber 111.

The amount of deformation of the piezoelectric member 121 varies even when the outer dimensions of the piezoelectric member 121 described above and the area of the upper electrode 123 are made the same. Studies by the inventors have revealed that such variations are mainly caused by variations in polarization characteristics of the piezoelectric member 121.

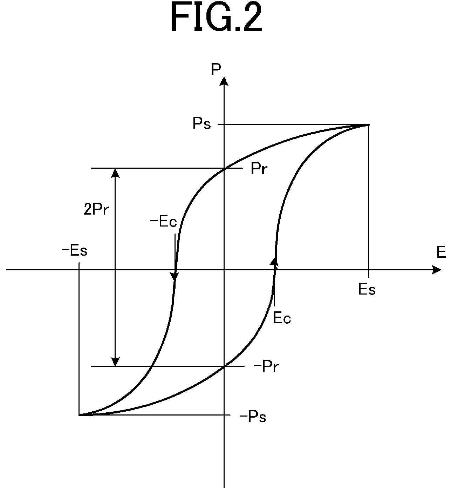

FIG. 2 is a diagram for explaining the polarization characteristics of the piezoelectric member 121.

As described above, the piezoelectric member 121 has spontaneous polarization because a ferroelectric material is used. That is, the piezoelectric member 121 has spontaneous polarizations ±Pr even when no voltage is applied. The residual polarization 2Pr is the difference between the spontaneous polarizations ±Pr.

In addition, in order to reverse the polarizations of the piezoelectric member 121, the piezoelectric member 121 needs to be placed in an electric field having the absolute value greater than a coercive electric field ±Ec. In order to deform the piezoelectric member 121, a voltage ±Vs is applied to the upper electrode 123 when the lower electrode 122 is at the ground potential as described above. The voltage ±Vs is a voltage at which an electric field ±Es having the absolute value greater than the coercive electric field ±Ec is obtained in the piezoelectric member 121. The voltage ±Vs is determined in relation to the thickness of the piezoelectric member 121, that is, the distance between the upper electrode 123 and the lower electrode 122. Thus, polarizations ±Ps whose absolute value is greater than that of the spontaneous polarizations ±Pr are generated.

The amount of polarization [C] depends on the area [m²] of the upper electrode 123 with which the piezoelectric member 121 having polarization P [C·m⁻²] is in contact. That is, variations in the polarizations ±Ps when the certain voltage ±Vs is applied lead to variations in the amount of polarization. As a result, the variations in the amount of deformation occurs in the piezoelectric member 121. Such variations in the polarization characteristics occurs under various conditions regardless of manufacturing methods, that is, the above-described film forming method, as well as processing methods such as dry etching and annealing. Therefore, it is difficult to completely equalize the polarization characteristics. On the other hand, the variations in the polarization characteristics generally occurs depending on a manufacturing apparatus and the like. By experimentally obtaining the dependency on a manufacturing apparatus and the like in advance, a variation pattern of the polarization characteristics in the plurality of piezoelectric members 121 in the inkjet head 1 produced by the manufacturing apparatus is identified. Therefore, contrary to the related art, the plan view areas of the upper electrodes 123, the plan view areas of the piezoelectric members 121, and the like can be intentionally made different from each other according to the variation pattern. The variations in the polarization characteristics can be offset by an appropriate distribution of the plan view areas.

The polarizations ±Ps at the certain voltage ±Vs correlate with the spontaneous polarizations ±Pr (residual polarization 2Pr). Therefore, the spontaneous polarizations ±Pr or the residual polarization 2Pr may be used as a polarization characteristic instead of the polarizations ±Ps. Alternatively, the difference value (Ps-Pr) between the polarization Ps and the spontaneous polarization Pr or the like may be used as a polarization characteristic. Furthermore, for example, Ps/(Es-Ec) or the like can also be used as a polarization characteristic, using electric field data such as the coercive electric field Ec.

For measurement of the polarization, a well-known technique such as the Sawyer-Tower circuit may be used. In this circuit, the piezoelectric member 121 and a standard capacitor with a known large capacitance are connected in series to an AC power source. The large capacitance referred to herein is sufficiently larger than the electrical capacitance of the piezoelectric member 121. The voltage at the standard capacitor has a value corresponding to charges stored in the standard capacitor, that is, an integral value of the current flowing through the standard capacitor. Since charges of the piezoelectric member 121 are equal to the charges of the standard capacitor, the relationship between the voltage applied by the AC power source and the voltage at the standard capacitor corresponds to the relationship between an electric field E and polarization P of the piezoelectric member 121. By obtaining the voltage at the standard capacitor while changing (sweeping) the applied voltage of the AC power supply, the polarization Ps, the spontaneous polarization Pr, the coercive electric field Ec, and the like are obtained. Alternatively, measurement of the residual polarization 2Pr may be performed using a commercially available device. Such devices include, for example, the Ferroelectric Characteristics Evaluation System FCE10 Series manufactured by TOYO Corporation and various ferroelectric/piezoelectric testers manufactured by Radiant Technologies Inc.

The residual polarization 2Pr as a polarization characteristic can be measured as long as the piezoelectric member 121 is in a state where electricity can be applied. For example, the measurement can be performed after the lower electrode and the upper electrode are formed on a chip on a wafer. Alternatively, the measurement may be performed on a single chip cut out from a wafer, or the measurement may be performed through a connector of the inkjet head after assembly of the inkjet head.

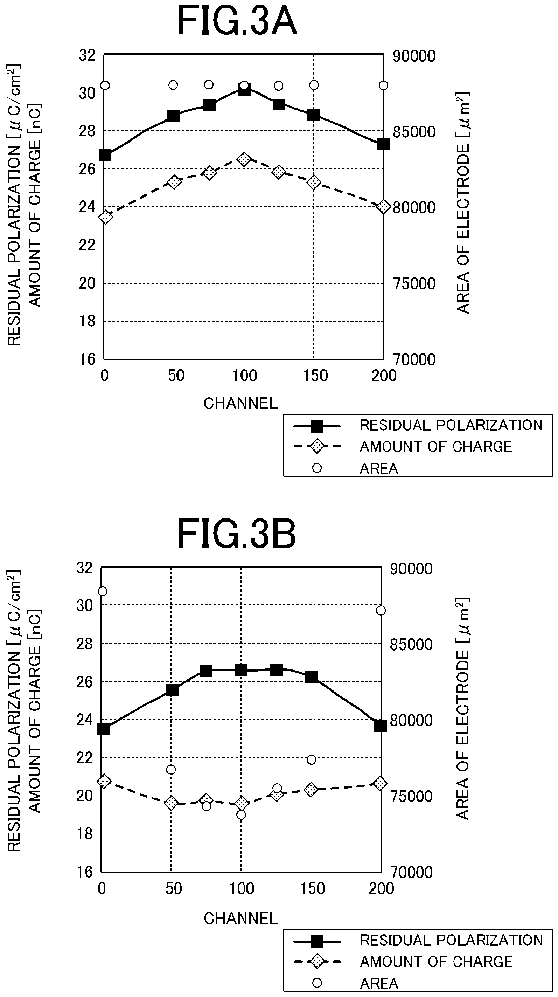

FIG. 3A and FIG. 3B are diagrams illustrating experimental results of an example of correction of the areas of the electrodes with respect to variations in the residual polarization.

Here, the inkjet head 1 in which nozzles N of 200 channels are aligned will be described as an example. The inkjet head 1 has a distribution in which the residual polarization 2Pr indicated by a circle is small at both ends and large near the center. FIG. 3A illustrates a distribution of a conventional example (before correction). If the area of the electrode indicated by a square is constant, the amount of charge of the piezoelectric member 121 generated by polarization when a certain voltage is applied varies so as to be large at the center and small at both ends depending on the residual polarization 2Pr, as indicated by a diamond.

In contrast, as illustrated in the present example (after correction) in FIG. 3B, it is possible to adopt a structure in which the area of the electrode is small at the center and large at both ends so as to offset the variations in the residual polarization 2Pr. That is, each electrode has an area corresponding to the polarization characteristic. As a result, the amount of charge of the piezoelectric member 121 generated when a certain voltage is applied becomes substantially constant. Therefore, it is possible to obtain the inkjet head 1 capable of suppressing variations in the ejection amount and the ejection speed of the ejected ink.

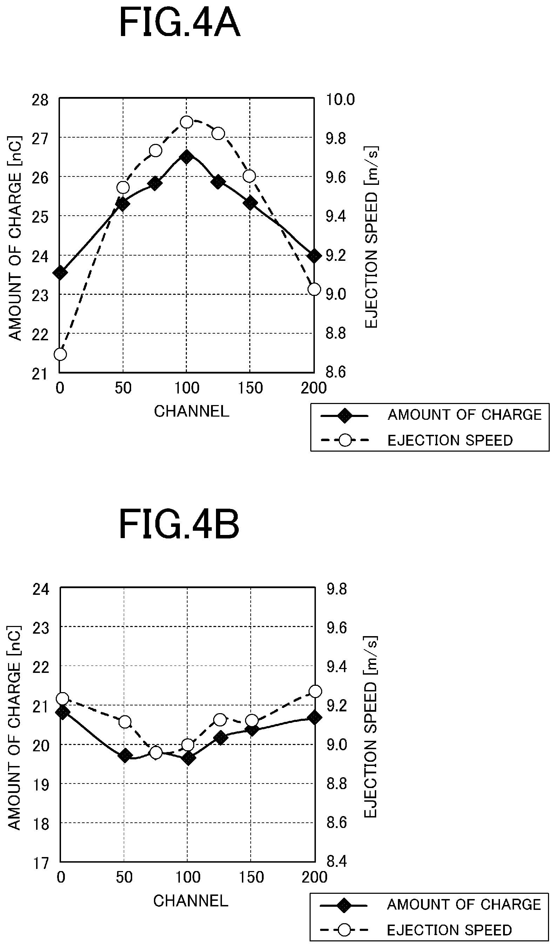

FIG. 4A and FIG. 4B are diagrams illustrating experimental results obtained by measuring the ejection speed of ink droplets according to the electrode area before and after the above-described correction, along with the amount of charge.

In a conventional example (before correction) illustrated in FIG. 4A, a large non-uniformity (10% or more) occurs in the ejection speed in accordance with a non-uniformity of the amount of charge. The speed of the ink droplets ejected from the nozzles N of the channels near the center is significantly higher than the speed of the ink droplets ejected from the nozzles N of the channels near both ends. As a result, landing positions of the ink droplets on a medium also vary.

In contrast, in the present example (after modification) illustrated in FIG. 4B, as described above, the variations in the amount of charge are suppressed to be small. Correspondingly, the non-uniformity of the ejection speed is also small and is suppressed to about several percent. As a result, the ink droplets land on the medium with minute unevenness, suppressing decrease in image quality.

Alternatively, instead of the electrode area, the plan view area of the piezoelectric member 121, mainly the width in plan view, that is, the diameter of a circle, the minor axis length of an ellipse, the short side length, or the like can be changed. In an ellipse or a plan view shape more complex than an ellipse, the shortest distance connecting two points on the outer periphery and passing through the center corresponds to the short side length. Alternatively, changing the plan view area (volume) of the pressure chamber 111 can also offset the effect of a pressure fluctuation on the ink due to the variations in the amount of deformation of the piezoelectric member 121. Also in this case, similarly to the piezoelectric member 121, in particular, the width of the pressure chamber 111 in plan view, for example, the short side length or the shortest distance connecting two points on the outer periphery and passing through the center of the pressure chamber 111 can be changed. The resonance frequency of the ink can be changed by changing a structural parameter such as the electrode area of the upper electrode 123, the plan view area of the piezoelectric member 121, and the plan view area of the pressure chamber 111. Since the shape is not originally designed to be strictly matched to the resonance frequency of the ink, a slight change does not cause a problem. However, if deviation of the resonance frequency of the ink from the operating frequency of the ink ejection becomes too large, the pressure fluctuation will no longer be appropriately applied to the ink. Therefore, the amount of change of the structural parameter is set such that the amount of deviation of the resonance frequency is within a reference range, for example, ±10% or less, more preferably ±5% or less from a reference frequency.

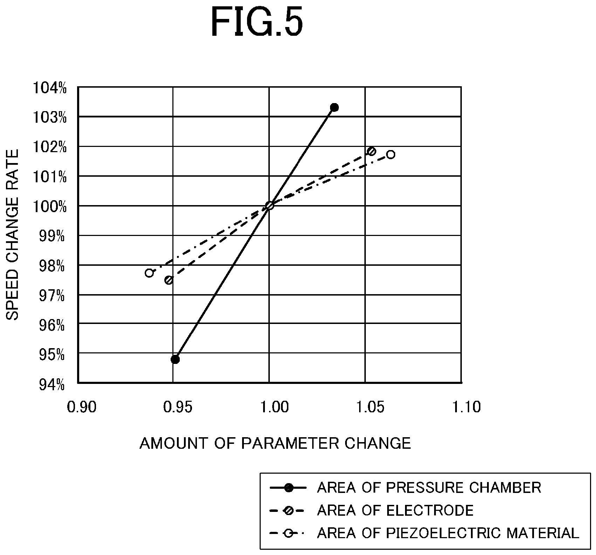

FIG. 5 is a diagram illustrating an ink ejection speed change rate with respect to a change of a structural parameter related to the offset of the variations in the polarization characteristic, represented as a relative change with respect to a reference parameter value.

It is shown that the ink ejection speed changes in a positive correlation with any of the electrode area, the plan view area of the piezoelectric member, and the plan view area of the pressure chamber.

Note that as can be seen from FIG. 5, the relationship between the change rate of each structural parameter and the change in the ink ejection speed is not linear. A correspondence relationship between the magnitude of the value of a polarization characteristic and the amount of change (amount of adjustment) of each structural parameter can be determined in advance as a conversion table or the like and stored and held. Correction of each structural parameter can be performed based on the conversion table.

In this way, by offsetting the variations in the polarization characteristic by correction of a structural parameter, it is possible to make the ink ejection speed (ejection amount) uniform with high precision. The degree of uniformity may be determined as appropriate according to precision required for the inkjet head 1. For example, the degree of uniformity can be within ±1%, more preferably within ±0.1%, from a reference speed.

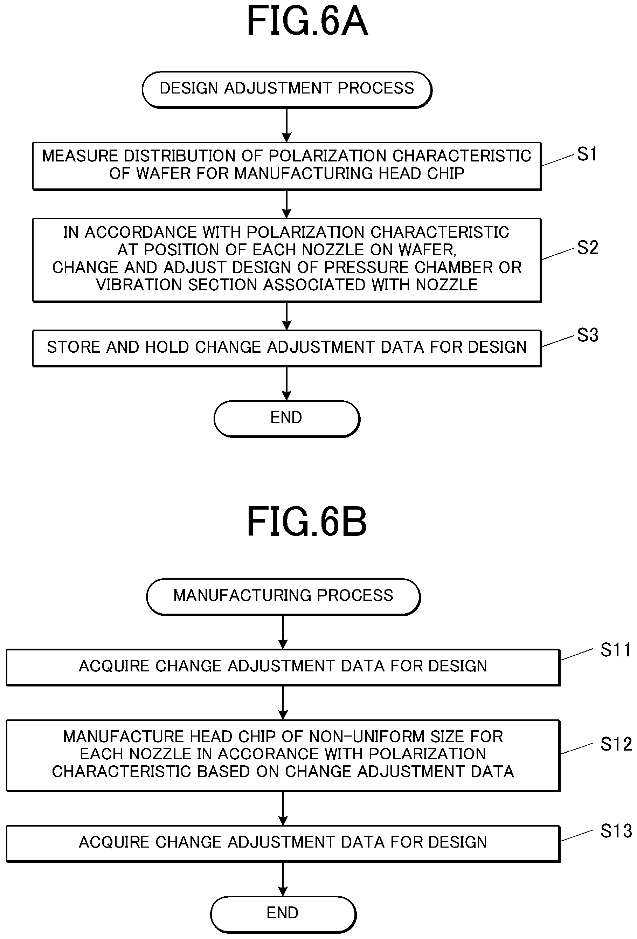

FIG. 6A and FIG. 6B are flowcharts illustrating procedures related to a method for manufacturing the inkjet head 1 (head chip 10) according to the present embodiment. FIG. 6A is a procedure of a design adjustment process, and FIG. 6B is a procedure of a manufacturing process of the inkjet head 1. Each of these processes can be performed by necessary apparatus configurations and/or human. Some processes may be partially performed by different apparatus configuration(s) and/or human from the other.

In the design adjustment process illustrated in FIG. 6A, first, a distribution of a polarization characteristic of a wafer produced by a wafer manufacturing apparatus for manufacturing the head chip 10 is measured (step S1). The polarization characteristic is not particularly limited as described above, but is, for example, the residual polarization 2Pr or the like.

The polarization characteristic at the position corresponding to each nozzle N on the wafer is acquired, and the size design of each of the pressure chamber 111, the piezoelectric member 121, and the upper electrode 123 is changed and adjusted according to the polarization characteristic (step S2). The changed and adjusted design data is stored and held (step S3). The design data referred to herein includes, for example, data on a coating range of a photosensitive member related to photolithography, data on a mask range related to etching, and the like. Then, the design adjustment process is complete.

The variations in the polarization characteristic mentioned above remains almost unchanged as long as wafers are manufactured under the same conditions using the same wafer manufacturing apparatus. Therefore, the design data once changed and adjusted can be repeatedly used for a plurality of times. However, the design data may be updated by executing the design adjustment process a plurality of times at appropriate time intervals.

In the manufacturing process illustrated in FIG. 6B, the above-described change adjustment information for design is acquired (step S11). Then, the head chip 10 having a non-uniform physical size corresponding to the polarization characteristic at the position of each nozzle N is manufactured by using the change adjustment data (step S12). A circuit board, an ink reservoir, and the like are attached to the head chip 10 to obtain the inkjet head 1 (step S13).

As described above, the present embodiment is a method for manufacturing the inkjet head 1 in which a voltage is applied to the piezoelectric member 121 to deform the piezoelectric member 121, thereby applying a pressure fluctuation to ink to cause the ink to be ejected. In this manufacturing method, a distribution of the ink ejection speed is corrected by a structure corresponding to a polarization characteristic of the piezoelectric member 121.

As described above, the present manufacturing method corrects, by a structural adjustment, the distribution of the ink ejection speed that varies depending on variations in the polarization characteristic of the piezoelectric member 121 related to the ink ejection from each nozzle N. Therefore, it is possible to easily obtain the inkjet head 1 capable of ejecting the ink with less variations from each nozzle N without performing an adjustment such as drive control during ejection control.

The polarization characteristic may be defined by the residual polarization 2Pr. In a ferroelectric material, the polarizations ±Ps at the certain voltage ±Vs are correlated with the residual polarization 2Pr. Therefore, the residual polarization 2Pr is appropriate as a value characterizing a polarization characteristic of the piezoelectric member 121 mainly made of a ferroelectric material.

Furthermore, in this inkjet manufacturing method, the area of the upper electrode 123 that applies a voltage to the piezoelectric member 121 is determined to be smaller for a portion of the piezoelectric member 121 having a larger residual polarization 2Pr. As a result, since the amounts of charges generated in the electrodes at the time of voltage application are adjusted to be equal to each other, variations in the amount of deformation of the pressure chamber 111 are suppressed. Therefore, the variations in the ink ejection speed are also reduced.

In addition, the inkjet head 1 according to the present embodiment includes a plurality of vibration sections 12 and ink channels. Each of the vibration sections 12 includes a piezoelectric member 121 and an upper electrode 123 that applies a voltage to the piezoelectric member 121. Each of the ink channels includes a pressure chamber 111. The pressure chamber 111 is deformed according to an operation of the vibration section 12 to apply a pressure fluctuation to the ink. In each of the vibration sections 12, the upper electrode 123 has an area corresponding to a polarization characteristic of the piezoelectric member 121. That is, in the inkjet head 1, variations in the polarization characteristic is offset by adjusting the size of the upper electrode 123.

Such a structure can be easily adjusted by setting etching range of the electrode layer or the like. Therefore, according to the present embodiment, it is possible to easily and more precisely obtain the inkjet head 1 capable of ejecting the ink with less variations.

Alternatively, in the inkjet head 1, the piezoelectric member 121 in each of the vibration sections 12 may have an area corresponding to a polarization characteristic of the piezoelectric member 121 in a plan view along the stacking direction of the piezoelectric member 121 and the upper electrode 123. That is, in the inkjet head 1, variations in the polarization characteristic may be offset by the plan view area of the piezoelectric member 121. The size of the piezoelectric member 121 can also be appropriately adjusted in a semiconductor manufacturing process. Therefore, according to the present embodiment, it is possible to easily obtain the inkjet head 1 capable of ejecting the ink more uniformly by suppressing the variations in the ink ejection due to the variations in the polarization characteristic.

Alternatively, in the inkjet head 1, the pressure chamber 111 may have an area corresponding to a polarization characteristic of the corresponding piezoelectric member 121 in a plan view along the stacking direction of the piezoelectric member 121 and the upper electrode 123. That is, in the inkjet head 1, variations in the polarization characteristic may be offset by adjusting the plan view size of the pressure chamber 111, for example, mainly the minor axis length or the short side length. The size of the pressure chamber 111 can also be appropriately changed in a semiconductor manufacturing process. Therefore, according to the present embodiment, it is possible to easily obtain the inkjet head 1 capable of ejecting the ink more uniformly by suppressing the variations in the ink ejection due to the variations in the polarization characteristic.

Furthermore, in the inkjet head 1, the polarization characteristic may be defined by the residual polarization 2Pr. The residual polarization 2Pr is a representative value that characterizes a polarization characteristic of the piezoelectric member, which is mainly a ferroelectric material. Since the adjustment amount can be appropriately determined in accordance with this value, the inkjet head 1 can perform uniform ink ejection in which the variations in the ink ejection are further suppressed.

Note that the present disclosure is not limited to the above embodiment, and various modifications are possible.

For example, in the above-described embodiment, the electrode area of the upper electrode 123, the plan area of the piezoelectric member 121, or the plan view area of the pressure chamber is changed and adjusted as a structural parameter for each corresponding nozzle N to offset the variations in the ink ejection speed due to the variations in the polarization characteristic. However, the variations in the ink ejection speed may be offset by structural adjustments such as sizes and shapes other than those described above.

Furthermore, in the above-described embodiment, the inkjet head 1 that ejects the ink by the piezoelectric member 121 vibrating in a deflection mode has been described. However, the inkjet head may eject the ink by deformation of the piezoelectric member vibrating in a shear mode. Also in this case, the size of each of the pressure chamber, the electrode, and the piezoelectric member is defined with reference to the stacking direction.

Furthermore, although it has been described in the above embodiment that, in the adjustment of the size, mainly the shortest distance connecting two points on the outer periphery and passing through the center such as the minor axis, or the short side is changed, it is not limited thereto. For example, the size (scale) may be changed without changing the shape, or the size in the major axis direction or any other axis direction may be changed.

In addition, it is only required that the pressure chamber 111 that applies a pressure fluctuation to the ink is located in the middle of the ink channel and faces the vibration plate 112. That is, the pressure chamber 111 may not have a structural difference from the preceding and following ink channels, for example, a difference in the channel diameter, a bend in the channel direction, or the like.

Further, distribution information of a polarization characteristic of a wafer or the like may be obtained simply by external measurement by another person.

In addition, the specific configurations, the contents and procedures of the processing operations, and the like described in the above embodiment can be appropriately changed without departing from the spirit and scope of the present invention. It is intended that the scope of the present invention includes the scope of the invention described in the scope of the claims and the scope of equivalents thereof.

### Industrial Applicability

The present invention can be used for an inkjet head manufacturing method and an inkjet head.

### Reference Signs List

1 inkjet head
10 head chip
11 channel member
111 pressure chamber
112 vibration plate
113 upstream supply path
114 downstream supply path
12 vibration section
121 piezoelectric member
122 lower electrode
123 upper electrode
13 nozzle plate
N nozzle

## Claims

1. A method for manufacturing an inkjet head configured to apply a voltage to a piezoelectric member to deform the piezoelectric member, thereby applying a pressure fluctuation to ink to cause the ink to be ejected, the method comprising correcting a distribution of an ejection speed of the ink by a structure that corresponds to a polarization characteristic of the piezoelectric member.

2. The method for manufacturing an inkjet head according to claim 1, wherein the polarization characteristic is defined by residual polarization.

3. The method for manufacturing an inkjet head according to claim 2, wherein an area of an electrode configured to apply a voltage to the piezoelectric member is made smaller for a portion having a larger residual polarization of the piezoelectric member.

4. An inkjet head comprising:
piezoelectric elements that include respective piezoelectric members and respective electrodes configured to apply a voltage to the piezoelectric members; and
ink channels that include respective pressure chambers configured to deform in accordance with an operation of the respective piezoelectric elements, thereby applying a pressure fluctuation to ink, wherein
the electrodes each have an area corresponding to a polarization characteristic of the respective piezoelectric members.

5. An inkjet head comprising:
piezoelectric elements that include respective piezoelectric members and respective electrodes configured to apply a voltage to the piezoelectric members; and
ink channels that include respective pressure chambers configured to deform in accordance with an operation of the respective piezoelectric elements, thereby applying a pressure fluctuation to ink, wherein
the piezoelectric members each have an area corresponding to a polarization characteristic of the respective piezoelectric members in a plan view along a stacking direction of the piezoelectric members and the electrodes.

6. An inkjet head comprising:
piezoelectric elements that include respective piezoelectric members and respective electrodes configured to apply a voltage to the piezoelectric members; and
ink channels that include respective pressure chambers configured to deform in accordance with an operation of the respective piezoelectric elements, thereby applying a pressure fluctuation to ink, wherein
the pressure chambers each have an area corresponding to a polarization characteristic of the respective piezoelectric members in a plan view along a stacking direction of the piezoelectric members and the electrodes.

7. The inkjet head according to any one of claims 4 to 6, wherein the polarization characteristic is defined by residual polarization.
